# EUROPEAN PATENT SPECIFICATION

(11) **EP 3 750 149 B1**
(45) Date of publication and mention of the grant of the patent: **02.04.2025**
(21) Application number: 19812458.8
(22) Date of filing: 31.01.2019
(51) Int. Cl.: G09G 3/32

(54) **DISPLAY PANEL**
ANZEIGETAFEL
PANNEAU D'AFFICHAGE

(30) Priority: 31.05.2018 KR 20180063098; 21.08.2018 KR 20180097414
(43) Date of publication of application: 16.12.2020
(73) Proprietor: Samsung Electronics Co., Ltd., Gyeonggi-do 16677 (KR)
(72) Inventor: KIM, Jinho, Suwon-si Gyeonggi-do 16677 (KR); KANG, Kisun, Suwon-si Gyeonggi-do 16677 (KR); SHIN, Sangmin, Suwon-si Gyeonggi-do 16677 (KR); LEE, Hoseop, Suwon-si Gyeonggi-do 16677 (KR); JUNG, Youngki, Suwon-si Gyeonggi-do 16677 (KR)
(74) Representative: Taor, Simon Edward William
(86) International application number: PCT/KR2019/001359
(87) International publication number: WO 2019/231073

(56) References cited:
- EP-A1- 3 389 037
- WO-A1-2016/196390
- KR-A- 20180 002 786
- KR-B1- 100 914 929
- US-A1- 2009 115 703
- US-A1- 2010 207 849
- US-A1- 2011 279 444
- US-A1- 2011 279 444
- US-A1- 2014 362 062
- US-A1- 2014 362 062
- US-B1- 7 088 051

## Description

### Technical Field

The disclosure relates to a display panel and a method for driving the display panel. More particularly, the disclosure relates to a display panel in which light emitting devices are included in a pixel, and a method for driving the display panel.

### Background Art

In related art, a display panel driving an inorganic light emitting device (hereinafter referred to as "LED") such as a red LED, a green LED, and a blue LED, as a sub pixel expresses a grayscale or gradation of the sub pixel by means of an amplitude of a driving current.

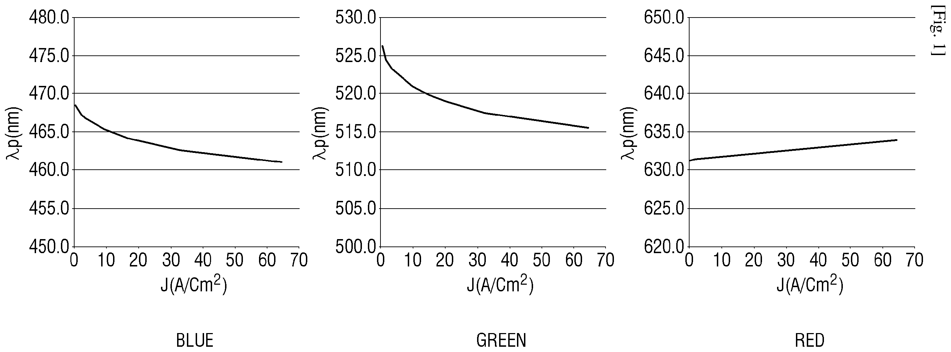

In this case, a wavelength as well as a grayscale or gradation of light emitted is shifted together according to an amplitude of the driving current, and thereby a color reproducibility of an image is reduced. FIG. 1 illustrates wavelength shifts according to a magnitude (or amplitude) of a driving current flowing through a blue LED, a green LED, and a red LED.

The above information is presented as background information only to assist with an understanding of the disclosure. No determination has been made, and no assertion is made, as to whether any of the above might be applicable as prior art with regard to the disclosure.

US 2010/207849 discloses a display device, including a substrate; a first layer having an array of row electrodes formed in rows across the substrate in a first direction and a second layer having an array of column electrodes formed in columns across the substrate in a second direction different from the first direction wherein the row and column electrodes overlap to form pixel locations; one or more layers of light-emitting material formed between the row and column electrodes to form a two-dimensional array of pixels, the pixels being located in the pixel locations; and a plurality of chiplets located over the substrate, the number of chiplets being less than the number of pixels, each chiplet exclusively controlling a subset of row electrodes and a subset of column electrodes, whereby the pixels are controlled to display an image.

WO 2016/196390 discloses methods and apparatuses relating to controlling an emission of a display panel. In one embodiment, a display driver hardware circuit includes row selection logic to select a number of rows in an emission group of a display panel, wherein the number of rows is adjustable from a single row to a full panel of the display panel, column selection logic to select a number of columns in the emission group of the display panel, wherein the number of columns is adjustable from a single column to the full panel of the display panel, and emission logic to select a number of pulses per data frame to be displayed, wherein the number of pulses per data frame is adjustable from one to a plurality and a pulse length is adjustable from a continuous duty cycle to a non-continuous duty cycle.

US 2014/362062 discloses a pixel circuit to drive an electro-optical element of a display backplane comprises an element driver coupled to the electro-optical element, a programming switch coupled to the element driver, and a driver switch coupled to the programming switch and the element driver. The driver switch is capable of controlling when the element driver is turned on or turned off, and is capable of pulse-width modulating the drive current provided to the electro-optical element.

US 2011/279444 discloses a display device including a display having a plurality of pixels, a compensator that for each of a plurality of pixels, calculates an image data compensation amount that compensates a characteristic deviation of a driving transistor of each pixel by measuring the first pixel current generated by the first data voltage and the second pixel current generated by the second data voltage obtained by amending the first data voltage, and initializes a panel capacitor that is parasitic on a plurality of data lines connected to the plurality of pixels in the measurement of the first pixel current and the measurement of the second pixel current; and a signal controller that generates an image data signal by reflecting the compensation amount of the image data.

EP 3389037 discloses a pixel circuit of a display panel is provided, which includes a light emitting element configured to emit light in accordance with a drive current, a current source including a driving transistor connected to the light emitting element, and the current source is configured to provide the drive current having a different amplitude to the light emitting element in accordance with a level of a voltage applied to a gate terminal of the driving transistor, an amplitude setting circuit configured to apply a voltage having a different level to the gate terminal of the driving transistor, and a pulse width control circuit configured to control a duration of the drive current by controlling the voltage applied to the gate terminal of the driving transistor.

### Disclosure of Invention

### Technical Problem

Provided is a display panel including a driving circuit to control an LED which is an inorganic light emitting device mounted on a glass substrate to be stably operated.

Further, provided is a display panel including a driving circuit appropriate for a highdensity integrated circuit by optimizing a design of a driving circuit driving an LED which is an inorganic light emitting device mounted on a glass substrate.

Further still, provided are a display panel that improves color reproducibility to an input image signal through an LED which is an inorganic light emitting device mounted on a glass substrate, and a display apparatus including the display panel.

### Solution to Problem

According to an aspect, there is provided a display panel as set out in claim 1. Additional features are set out in claim 2.

### Advantageous Effects of Invention

According to embodiments of the disclosure, a wavelength shift according to a grayscale or gradation of an inorganic light emitting device included in a display panel can be prevented. In addition, it is possible to correct a stain or color of the inorganic light emitting device included in the display panel. In addition, even in a case that a large-area tiled display panel is configured by combining a display panel in the form of a plurality of modules, a difference of brightness or color among the respective display panel modules can be corrected.

Other aspects, advantages, and salient features of the disclosure will become apparent to those skilled in the art from the following detailed description, which, taken in conjunction with the annexed drawings, discloses various embodiments of the disclosure.

### Brief Description of Drawings

The above and other aspects, features, and advantages of certain embodiments of the present disclosure will be more apparent from the following description taken in conjunction with the accompanying drawings, in which:
FIG. 1 is a diagram illustrating a wavelength shift according to a magnitude of a driving current flowing through a blue LED, a green LED, and a red LED according to an embodiment;
FIG. 2A is a diagram illustrating a pixel structure of a display panel, according to an embodiment;
FIG. 2B is a diagram illustrating a sub-pixel structure, according to an embodiment;
FIG. 3 is a block diagram illustrating a configuration of a display panel, according to an embodiment;
FIG. 4 is a cross-sectional view of a display panel, according to an embodiment;
FIG. 5 is a cross-sectional view of a display panel, according to an embodiment;
FIG. 6 is a plane view illustrating a thin film transistor (TFT) layer, according to an embodiment;
FIG. 7 is a block diagram of a driving circuit included in a display panel, according to an embodiment;
FIG. 8 is a detailed circuit diagram of a driving circuit illustrated in FIG. 7 according to an embodiment;
FIG. 9 is a timing diagram of various signals for driving a driving circuit, according to an embodiment;
FIG. 10 is a timing diagram of various signals for driving an entire plurality of driving circuits included in a display panel according to an embodiment;
FIG. 11 is a circuit diagram of a driving circuit including transistors respectively implemented as n-type metal-oxide-semiconductor field-effect transistor (n-MOSFET) according to an embodiment;
FIG. 12 is a diagram illustrating a configuration of a display apparatus, according to an embodiment; and
FIG. 13 is a flowchart illustrating a method for driving a display panel, according to an embodiment.

### Best Mode for Carrying out the Invention

### Mode for the Invention

In the following description, well-known functions or constructions are not described in detail since they would obscure the application with unnecessary detail. In addition, repeated descriptions of the same element are omitted as much as possible.

In the drawings, the same reference numerals are used to represent the same elements.

The term "unit" as it appears in the disclosure does not itself have a distinct meaning or serve a particular purpose beyond the generally understood meaning of the term.

The terms used in the following description are provided to explain embodiments and are not intended to limit the scope. It is to be understood that the singular forms "a," "an," and "the" include plural referents unless the context clearly dictates otherwise.

Throughout this specification, it will be understood that the terms "comprise" and "include" and variations thereof, such as "comprising", "comprises", "including", and "includes", specify the presence of features, numbers, steps, operations, components, parts, or combinations thereof, described in the specification, but do not preclude the presence or addition of one or more other features, numbers, steps, operations, components, parts, or combinations thereof.

In the description, the terms "first, second, and so forth" are used to describe diverse elements regardless of their order and/or importance and to discriminate one element from other elements, but are not limited to the corresponding elements.

If it is described that a certain element (for example, first element) is "operatively or communicatively coupled with/to" or is "connected to" another element (for example, second element), it should be understood that the certain element may be connected to the other element directly or through still another element (for example, third element).To the contrary, it will be understood that when an element (for example, a first element) is "directly coupled with/to" or "directly connected to" another element (for example, a second element), there is no intervening element (for example, a third element) between the element and another element. When it is mentioned that one element (for example, first element) is "directly coupled" with or "directly connected to" another element (for example, second element), it may be understood that there is no element (for example, third element) present between one element and another element.

Unless indicated otherwise, it is to be understood that all the terms used in the disclosure including technical and scientific terms have meanings as understood by those having ordinary skill in the art.

Hereinafter, the present disclosure will be described in detail with reference to the accompanying drawings.

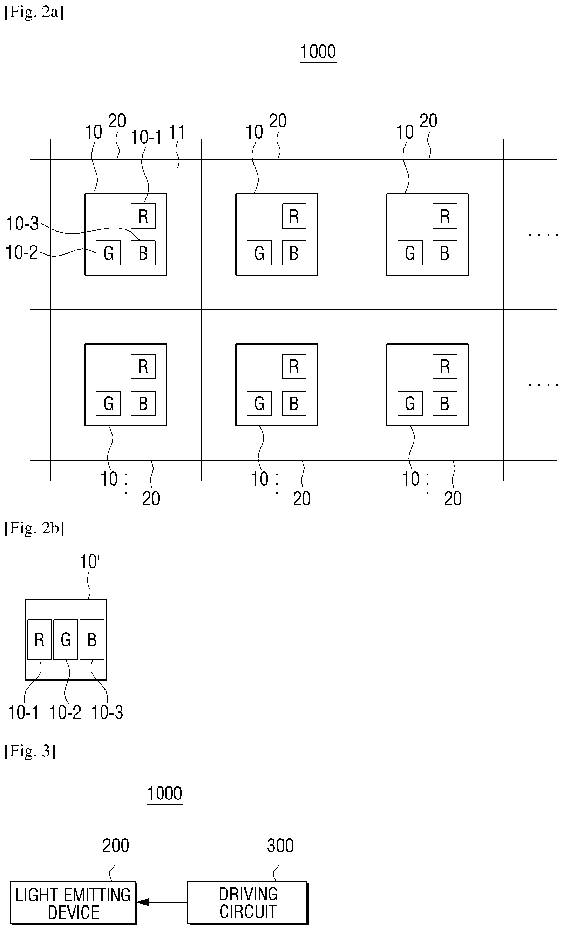

FIG. 2A is a diagram illustrating a pixel structure of a display panel 1000, according to an embodiment. As illustrated in FIG. 2A, the display panel 1000 includes a plurality of pixels 10 which are arranged in a matrix form.

The respective pixels 10 include a plurality of sub-pixels 10-1, 10-2 and 10-3. For example, one pixel 10 included in the display panel 1000 may include a sub-pixel of three types: a red (R) sub-pixel 10-1, a green (G) sub-pixel 10-2, and a blue (B) sub-pixel 10-3. That is, one set of R, G and B sub-pixels may constitute a unit pixel of the display panel 1000.

Referring to FIG. 2A, it may be understood that one pixel area 20 of the display panel 1000 may include an area 10 occupied by pixels, and a remaining peripheral area 11.

The area 10 occupied by pixels 10 may include the R, G and B sub-pixels 10-1 to 10-3.The R sub-pixel 10-1 may include an R light emitting device and a driving circuit for driving the R light emitting device. The G sub-pixel 10-2 may include a G light emitting device and a driving circuit for driving the G light emitting device. The B sub-pixel 10-3 may include a B light emitting device and a driving circuit for driving the B light emitting device. Referring to FIG. 2A, it may be understood that the sub-pixels 10-1 to 10-3 in the one pixel 10 are arranged in an L shape. The left and right sides of the L shape may be reversed.

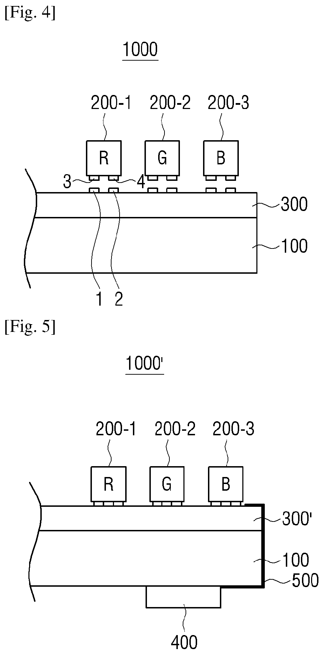

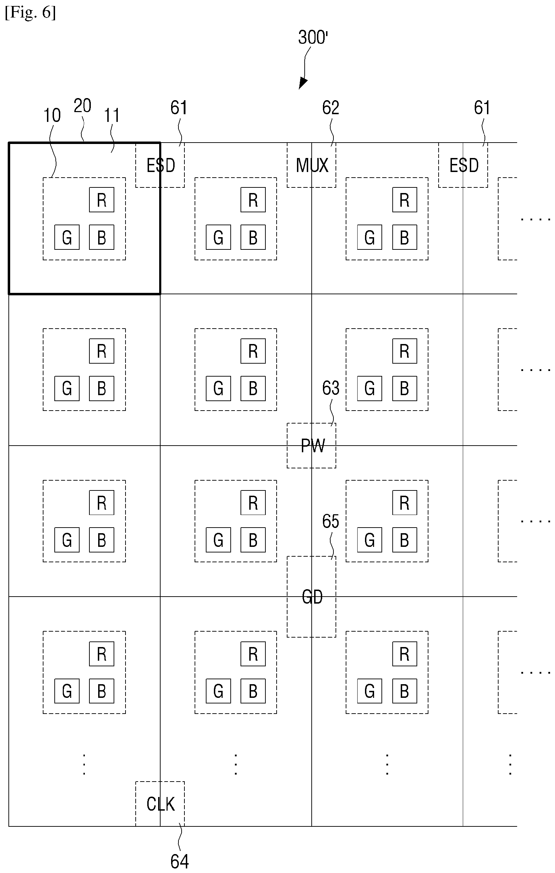

The remaining area 11 peripheral to the pixel 10 may, as will be described with reference to FIGS. 5 and 6, include various circuits for driving the driving circuit according to an embodiment.

FIG. 2B is a diagram illustrating a sub-pixel structure, according to another embodiment. As illustrated in FIG. 2B, the R, G and B sub-pixels 10-1 to 10-3 may be arranged in a row inside a pixel. However, the disposition form of the sub-pixels is only an example, and a plurality of sub-pixels may be disposed in various forms inside the respective pixels.

In the example described above, a pixel includes three types of sub-pixels, but is not limited thereto. For example, a pixel may be implemented of four types such as R, G, B and white (W), and according to an embodiment, a different number of pixels may be included in one pixel. Hereinafter, an example in which the pixel 10 includes a sub-pixel of three types such as R, G and B will be described for convenience of explanation.

FIG. 3 is a block diagram illustrating a configuration of a display panel, according to an embodiment. Referring to FIG. 3, the display panel 1000 includes a driving circuit 300 and a light emitting device 200. As will be described later, the display panel 1000 includes a driving circuit 300 formed on the glass 100, and a light emitting device 200 formed on the driving circuit 300.

The light emitting device 200 are included in the sub-pixels 10-1 to 10-3 of the display panel 1000, and emit light according to driving of the driving circuit 300. The light emitting device 200 may be of a plurality of types according to a color of light emitted. For example, a red (R) light emitting device emitting light in red color, a green (G) light emitting device emitting light in green light, and a blue (B) light emitting device emitting light in blue color may be included.

A type of sub-pixel may be determined according to a type of the light emitting device 200 included in the sub-pixel. That is, the R light emitting device may be included in the R subpixel 10-1. The G light emitting device may be included in the G sub-pixel 10-2. The B light emitting device may be included in the B sub-pixel 10-3.

The light emitting device 200 is an inorganic light emitting device (or an inorganic light emitting diode) by means of an inorganic material which is different from an organic light emitting device (or an organic light emitting diode, OLED) fabricated using an organic material. Hereinafter, the LED refers to an inorganic light emitting device which is distinguished from the OLED.

According to an embodiment, the inorganic light emitting device may be a micro light emitting diode (micro-LED).The micro LED refers to a subminiature inorganic light emitting device of a size less than or equal to 100 micrometers (µm) self-illuminating without a backlight or a color filter.

The driving circuit 300 drives the light emitting device 200. For example, the driving circuit 300 may drive the light emitting device 200 and express a gray scale or gradation of the sub-pixel. As described above, each one of the sub-pixels includes a light emitting device, and thus, unlike a liquid crystal display (LCD) panel using a plurality of LEDs emitting light in a single color as a backlight, the driving circuit 300 may drive the light emitting device 200 and differently express a grayscale or gradation for each sub-pixel.

To this end, the respective sub-pixels included in the display panel 1000 are implemented as the light emitting device 200 and a driving circuit 300 for driving the light emitting device 200. That is, the driving circuit 300 for driving the respective device 200 is present for each sub-pixel.

According to an embodiment, the driving circuit 300 uses pulse amplitude modulation (PAM) drive or pulse width modulation to drive the light emitting device 200. That is, the driving circuit 300 may control an amplitude and pulse width of a driving current driving the light emitting device 200 together, and provide, to the light emitting device 200, the driving current of which the amplitude and pulse width are controlled together.

The amplitude and pulse width of the driving current being controlled "together" does not mean that the amplitude and pulse width of the driving current are controlled simultaneously in time, but means that the PAM drive method and the PWM drive method are employed together to express a grayscale or gradation.

The PWM drive method is a method of expressing a grayscale or gradation according to a duration of light emission of the light emitting device 200. Accordingly, in a case that the light emitting device 200 is driven using the PWM method, even if the driving current has the same amplitude, it is possible to express various grayscales or gradations by adjusting the pulse width of the driving current and controlling the duration of light emission of the light emitting device 200. Accordingly, it is possible to resolve the problem that occurs in a case in which an LED is driven using the PAM method alone, namely, that a wavelength shift of light emitted by an LED (in particular, micro-LED) may occur as a grayscale or gradation is adjusted.

To this end, the driving circuit 300 includes a current source, a PAM driving circuit and a PWM driving circuit for each sub pixel, which will be described in greater detail below.

FIG. 4 is a cross-sectional view of a display panel 100, according to an embodiment. With reference to FIG. 4, only one pixel included in the display panel 1000 is described for convenience of explanation.

Referring to FIG. 4, the driving circuit 300 is disposed (or arranged) on a glass 100, and the respective light emitting devices R, G and B 200-1 to 200-3 are arranged (or mounted) on the driving circuit 300 and included in the respective sub pixels 10-1 to 10-3.

As described above, the display panel 1000 in which the driving circuit 300 and the light emitting devices 200-1 to 200-3 are disposed on the glass 100 may be referred to as a display panel of a chip on glass (COG) type. The display panel of the COG type is different from a display panel of a chip on board (COB) type in which a driving circuit and a light emitting device layer are disposed on a substrate such as a synthetic resin and the like.

The driving circuit 300 may be implemented as a thin film transistor (TFT) and included in a TFT layer. In this case, the TFT may be a low temperature poly silicon (LTPS) TFT, but is not limited thereto. The TFT layer 300 disposed on the glass 100 and the glass 100 may be added together and referred to as a TFT panel or a glass substrate. A type or characteristic of the glass 100 included in the glass substrate is not related to the embodiments so that an explanation thereof is omitted.

Although not distinguishably illustrated in the drawings expressly, the driving circuit 300 for driving the respective light emitting devices 200-1 to 200-3 is present on the driving circuit layer 300 for each of the light emitting devices 200-1 to 200-3. Accordingly, the light emitting devices R, G and B 200-1 to 200-3 are arranged on the driving circuit 300 so that they are respectively electrically connected to the corresponding driving circuit 300.

As illustrated in FIG. 4, the R light emitting device 200-1 may be mounted or arranged so that an anode electrode 3 and cathode electrode 4 of the R light emitting device 200-1 are respectively connected to an anode electrode 1 and cathode electrode 2 disposed on the driving circuit 300 for driving the R light emitting device 200-1, and the same applies to the G light emitting device 200-2 and the B light emitting device 200-3. According to an embodiment, any one of the anode electrode 1 and the cathode electrode 2 may be implemented as a common electrode.

With reference to FIG. 4, an example in which the light emitting device 200-1 to 200-3 is a micro-LED of a flip chip type is described. However, the example is not limited thereto, and according to an embodiment, the light emitting device 200-1 to 200-3 may be a micro-LED of a lateral type or a micro-LED of a vertical type.

According to an embodiment, the display panel 1000 may further include a multiplexer (MUX) circuit for selecting any one of the plurality of sub pixels 10-1 to 10-3 included in the pixel 10, an electro static discharge (ESD) circuit for preventing a static electricity occurring on the display panel 1000, a power circuit for supplying power to the driving circuit 300, a clock provision circuit for providing a clock driving the driving circuit 300, at least one gate driver for driving pixels of the display panel 1000 arranged in a matrix form by the horizontal line (or by the row), a data driver (or a source driver) for providing a data voltage (for example, amplitude setup voltage) or a pulse width setup voltage to the respective pixels or to the respective sub-pixels, and so on.

An example display panel further comprising these various circuits will be described in greater detail below with reference to FIGS. 5 and 6. In FIGS. 5 and 6, the same elements described above will not be described in detail.

FIG. 5 is a cross-sectional view of a display panel 1000', according to an embodiment. As illustrated in FIG. 5, the display panel 1000' may include a TFT layer 300' including a driving circuit 300 disposed on the glass 100, a light emitting device 200-1 to 200-3 disposed on the driving circuit 300 and included in a sub pixel of the display panel 1000', various circuits 400 for driving the driving circuit 300, and a connection cable 500 electrically connecting the TFT layer 300' with the various circuits 400.

The TFT layer 300' may include a driving circuit 300 realized as a TFT, and may be formed on a first surface of the glass 100.

The various circuits 400 may include a MUX circuit for operation of the driving circuit 300, an electro static discharge (ESD) circuit, a power circuit, a clock provision circuit, a gate driver, a data driver, and etc., and may be disposed or arranged on a second surface of the glass 100.

According to an embodiment, the connection cable 500 of the display panel 1000' may be disposed in an edge area of a TFT substrate, and the TFT layer 300' disposed on a first surface of the glass 100 and the various circuits 400 disposed on a second surface of the glass 100 may be electrically connected via the connection cable 500.

The connection cable 500 is disposed in the edge area of the TFT substrate because otherwise, a crack may occur on the glass due to a difference of temperature between a fabrication process of a TFT substrate and a process of filling a hole with conductive materials, where a hole penetrating the glass 100 is disposed and circuits arranged on the opposite sides of the glass 100 are connected to each other,

In the example described above, all circuits for operation of the driving circuit 300 are, as in the reference numeral 400, separately disposed on the opposite side of the glass 100 surface on which the TFT layer 300' is disposed. However, the example is not limited thereto. That is, all or some of the various circuits may be disposed on the TFT layer 300'.

For example, all the various circuits described above may be disposed on the TFT layer 300', in which case, it is not necessary that a circuit is additionally arranged on the other surface of the glass 100 and accordingly, the connection cable 500 of FIG. 5 connecting front and rear surfaces of the glass 100 would not be necessary, either.

As another example, the MUX circuit, the ESD circuit, the power circuit, the clock provision circuit, and the gate driver may be implemented as a TFT and included in the TFT layer 300', and the display panel may be implemented in such a way that the data driver circuit is additionally arranged on the other side of the glass 100. FIG. 6 is a diagram provided to explain such an embodiment.

FIG. 6 is a cross-sectional view of a TFT layer 300', according to an embodiment. In detail, FIG. 6 illustrates a disposition of various circuits included in the TFT layer 300' of the display panel 1000'. Referring to FIG. 6, an entire pixel area 20 occupied by one pixel in the TFT layer 300' may include an area 10 in which various driving circuits 300 for driving the respective R, G and B sub pixels are arranged, and a peripheral remaining area 11. According to an embodiment, a size of the area 10 occupied by a driving circuit for the respective R, G and B sub pixels may be, for example, a size of about a quarter of the entire pixel area 20, but is not limited thereto.

As described above, one pixel area 20 may include the remaining area 11, and so may the other pixels. That is, according to an embodiment, many spaces other than an area occupied by the driving circuit 300 are present in the TFT layer 300', and thus, the ESD circuit 61, the MUX circuit 62, the power circuit 63, the clock provision circuit 64, and the gate driver circuit 65 may be implemented as a TFT and included in the remaining area 11 of the TFT layer 300' as illustrated in FIG. 6. In this case, the data driver circuit may be arranged on the other surface of the glass 100 as in the reference numeral 400 of FIG. 5.

The location, size and number of the respective ESD circuit 61, the MUX circuit 62, the power circuit 63, the clock provision circuit 64, and the gate driver circuit 65 is only an nonlimiting example.

In addition, an embodiment in which various circuits are arranged on both sides as being divided based on the glass 100 is not limited to the example of FIG. 6, and at least one circuit from among the ESD circuit 61, MUX circuit 62, power circuit 63, clock provision circuit 64, and gate driver circuit 65 of FIG. 6 may be arranged on the other surface of the glass 100 as in the reference numeral 400.

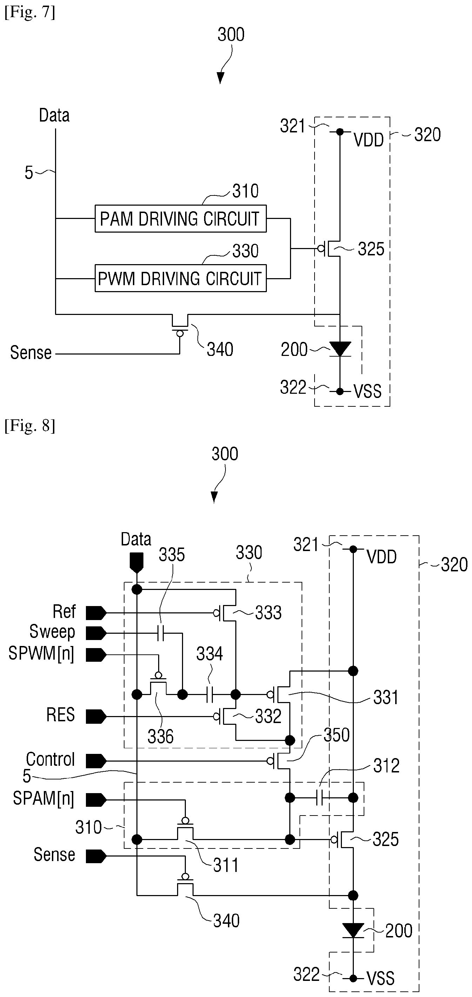

A constitution and operation of the driving circuit 300 according to various embodiments will not be described in detail with reference to FIGS. 7-11.

FIG. 7 is a block diagram of a driving circuit 300 included in a display panel 1000 and/or 1000', according to an embodiment. Referring to FIG. 7, the display panel 1000 and/or 1000' includes a light emitting device 200 and a driving circuit 300. In this case, the driving circuit 300 includes a PAM driving circuit 310, a current source 320, and a PWM driving circuit 330.

As described above, the driving circuit 300 is provided for each sub pixel, and one driving circuit 300 drives one sub pixel and thus may be referred to as a pixel circuit depending on circumstances. In this case, the PAM driving circuit 310 may be referred to as a PAM pixel circuit, and the PWM driving circuit 330 may be referred to as a PWM pixel circuit. For convenience of explanation, the terms "driving circuit" "PWM driving circuit" and "PWM driving circuit 330" are used to describe an embodiment.

FIG. 7 illustrates one sub pixel-related circuit, that is, one light emitting device 200, and a driving circuit 300 for driving the light emitting device 200. Accordingly, the light emitting device 200 and driving circuit 300 as illustrated in FIG. 7 are provided in the display panel 1000 and/or 1000' by the sub pixel. The light emitting device 200 may be a micro-LED in any one color from among R, G and B.

The light emitting device 200 emits light according to a driving current provided by the current source 320. For example, the light emitting device 200 may emit light with different brightness according to an amplitude or pulse width of the driving current provided from the current source 320. Here, the pulse width of the driving current may be expressed as a duty ratio of the driving current or a driving time of the driving current.

For example, the light emitting device 200 may emit light of a higher brightness with the increase in the amplitude of the driving current and with the increase in the pulse width (that is, with the increase in the duty ratio or with the increase in the driving time). However, the example is not limited thereto.

The current source 320 provides a driving current to the light emitting device 200. In this case, the current source 320 includes a first transistor 325 connected to the light emitting device 200, and may provide a driving current of different amplitudes to the light emitting device 200 according to an amplitude of voltage applied to a gate terminal of the first transistor 325.

The current source 320 may provide a driving current 200 of an amplitude corresponding to the amplitude of voltage applied to the gate terminal of the first transistor 325 to the light emitting device 200 via the PAM driving circuit 310. In this case, the voltage of the gate terminal of the first transistor 325 may be controlled via the PWM driving circuit 330 and a pulse width of the driving current may be controlled.

The PWM driving circuit 330 controls the pulse width of the driving circuit provided to the light emitting device 200. For example, the PWM driving circuit 330 may control a voltage applied to the gate terminal of the first transistor 325 according to a pulse width data applied through a data line 5, and control a duration of the driving current, that is, a duration of light emission of the light emitting device 200. Here, the pulse width data is a pulse width setup voltage determining a pulse width of the driving current, but is not limited thereto.

The PWM driving circuit 330 includes two transistors connected to each other using a so-called "diode connected method". For example, the PWM driving circuit 330 includes a fourth transistor (331 of FIG. 8), and a fifth transistor (332 of FIG. 8) connected to a gate terminal and drain terminal of the fourth transistor (331 of FIG. 8).

Accordingly, in the operation process of the PWM driving circuit 330, a voltage in which a threshold voltage of the fourth transistor 331 is taken into consideration may be applied to the gate terminal of the fourth transistor 331.

According to an embodiment, a deviation of pulse width of the driving circuit 300 occurring due to a deviation among the driving circuits 300 included in the respective sub pixels of the display panel 1000 and/or 1000' (in other words, a deviation of threshold voltage among fourth transistors included in the respective driving circuit 300) can be compensated.

As described above, a method of compensating a threshold voltage of a fourth transistor 331 through a connection structure of the fourth transistor 331 and a fifth transistor 332 in the PWM driving circuit 330 may be referred to as "internal compensation" or "Vth internal compensation".

The PAM driving circuit 310 controls an amplitude of the driving circuit provided to the light emitting device 200. The PWM driving circuit 310 applies amplitude data received through the data line 5 to a gate terminal of the first transistor 325, and controls the amplitude of the driving current. The amplitude data may be a particular voltage or an amplitude setup voltage which will be described later, but is not limited thereto.

According to an embodiment, an amplitude setup voltage corrected based on a current flowing through the light emitting device 200 is applied to the PWM driving circuit 310.

To sense a current flowing through the light emitting device 200, the driving circuit 300 includes a second transistor 340. The second transistor 340 may transfer a current flowing through the first transistor 325 to the data line 5.

In detail, the second transistor 340 is connected to in between the first transistor 325 and the data line 5, and may be turned on according to a control signal (Sense) and transfer a current flowing through the first transistor 325 to the data line 5. The current flowing through the data line 5 may be sensed by a current sensor outside of the driving circuit 300.

According to an embodiment, a processor outside of the driving circuit 300 or a timing controller (TCON) may correct an amplitude setup voltage based on the current sensed as above, and apply the corrected amplitude setup voltage to the PAM driving circuit 310.

Accordingly, a deviation of amplitude of the driving circuit 300 occurring due to a deviation among the driving circuits 300 included in the respective sub pixels of the display panel 1000 and/or 1000' (in other words, a deviation of threshold voltage among first transistors included in the respective driving circuit 300) can be compensated.

As described above, a method of compensating a threshold voltage of the first transistor 325 by sensing a current flowing through the first transistor 325 and correcting an amplitude setup voltage may be referred to "external compensation" or "Vth external compensation". As described above, in the driving circuit 300 according to an embodiment, it is possible to control a light emitting device included in a display panel not only by a PAM method but also by a PWM method. Accordingly, a grayscale or gradation may be expressed by a driving current of the same amplitude, and thereby a wavelength shift of a light emitting device according to an amplitude of the driving current can be resolved.

In addition, a deviation of threshold voltage among the first transistors 325 included in each of a plurality of driving circuits included in the display panel 1000 and/or 1000' and a deviation of threshold voltage among the fourth transistors 331 included in each of the plurality of driving circuits included in the display panel 1000 and/or 1000' may be compensated, and thereby it is possible to correct a stain of the display panel and a color deviation among light emitting devices occurring due to the deviation of threshold voltage among the first transistors and the deviation of threshold voltage among the fourth transistors.

In addition, according to an embodiment, even in a case that the display panel 1000 and/or 1000' is one module included in a tiled display panel for which a plurality of modules are combined with one another, a difference of brightness of color among the respective modules may be corrected.

The following will explain the details and operation of the driving circuit 300 in detail by referring to FIGS. 8 to 10. FIG. 8 illustrates a detailed circuit diagram illustrating the driving circuit 300 illustrated in FIG. 7. In an embodiment, the driving circuit 300 includes a first transistor 325, a second transistor 340, a third transistor 311, a fourth transistor 331, a fifth transistor 332, a sixth transistor 333, a seventh transistor 336, and an eighth transistor 350. In an embodiment, the driving circuit 300 includes a first capacitor 312, a second capacitor 334, and a third capacitor 335.

Referring to FIG. 8, the display panel 1000 and/or 1000' includes a light emitting device 200 and a driving circuit 300. In this case, the driving circuit 300 includes a PAM driving circuit 310, a current source 320, a PWM driving circuit 330, a second transistor 340, and an eighth transistor 350.

The PAM driving circuit 310 applies a voltage input through the data line 5 to a gate terminal of the first transistor 325.

To this end, the PAM driving circuit 310 includes a third transistor 311 of which a source terminal is connected to the data line 5 and a drain terminal is connected to a gate terminal of the first transistor 325, and a first capacitor 312 of which one terminal is connected to a source terminal of the first transistor 325 and the other terminal is commonly connected to the gate terminal of the first transistor 325 and a drain terminal of the third transistor 311.

The PAM driving circuit 310, when an amplitude setup voltage (PAM data) is input through the data line 5 while the third transistor 311 is turned on according to a control signal (SPAM(n)), charges the input amplitude setup voltage in the first capacitor 312, and applies the voltage charged in the first capacitor 312 to the gate terminal of the first transistor 325.

As illustrated in FIG. 8, the source terminal of the first transistor 325 is commonly connected to one terminal of the first capacitor 312 and a driving voltage terminal 321 of the driving circuit 300. The drain terminal of the first transistor 325 is connected to an anode terminal of the light emitting device 200, and the drain terminal of the light emitting device 200 is connected to a ground voltage terminal 322 of the driving circuit 300.

The current source 320 may, in a state that a driving voltage (VDD) is applied to the driving voltage terminal 321 and the voltage charged in the first capacitor 312 is applied to the gate terminal of the first transistor 325, when a voltage of the ground voltage terminal 322 becomes a ground voltage (VSS), provide, to the light emitting device 200, a driving current of an amplitude corresponding to an amplitude of the voltage charged in the first capacitor 312.

As illustrated in FIG. 8, for the eighth transistor 350, the drain terminal is connected to the gate terminal of the first transistor 325, the source terminal is commonly connected to a drain terminal of the fourth transistor 331 and a drain terminal of the fifth transistor 332, and the PAM driving circuit 310 and the PWM driving circuit 330 may be electrically connected to or separated from each other according to a control signal (Control) using the eighth transistor 350.

The PWM driving circuit 330, when a pulse width setup voltage determining a pulse width of a driving current is applied through the data line 5, controls a voltage of the gate terminal of the first transistor 325 on the basis of the pulse width setup voltage.

To this end, the PWM driving circuit 330 includes a fourth transistor 331, a fifth transistor 332 connected to a gate terminal and drain terminal of the fourth transistor 331, a sixth transistor 333 having a drain terminal that is commonly connected to the gate terminal of the fourth transistor 331 and a source terminal of the fifth transistor 332, a second capacitor 334 of which one terminal is commonly connected to the gate terminal of the fourth transistor 331, the source terminal of the fifth transistor 332 and the drain terminal of the sixth transistor 333, a third capacitor 335 of which one terminal receives input of a sweep signal and the other terminal is connected to the other terminal of the second capacitor 334, and a seventh transistor 336 of which a source terminal is connected to the data line 5 and a drain terminal is commonly connected to the other terminal of the second capacitor 334 and the other terminal of the third capacitor 335.

In this case, the eighth transistor 350 is connected to the gate terminal of the first transistor 325 and the drain terminal of the fourth transistor 331.

A gate terminal voltage of the fourth transistor 331 may be a voltage based on a threshold voltage of the fourth transistor 331 while the fifth transistor 332 is turned on. Thereafter, while the seventh transistor 336 is turned on according to a control signal (SPWM(n)), when a pulse width setup voltage (PWM data) is input through the data line 5, the gate terminal voltage of the fourth transistor 331 may be a voltage based on the threshold voltage and pulse width setup voltage of the fourth transistor 331, and thereafter, when a linearly shifting sweep signal is input through one terminal of the third capacitor 335, the gate terminal voltage of the fourth transistor 331 may be linearly shifted according to the sweep signal.

When the linearly-shifted gate terminal voltage of the fourth transistor 331 reaches the threshold voltage of the fourth transistor 331, the fourth transistor 331 may be turned on and a driving voltage (VDD) applied to the source terminal of the fourth transistor 331 may be applied to the gate terminal of the first transistor 325 through the drain terminal of the fourth transistor 331 (in this case, it is necessary that the eighth transistor 350 is also turned on according to the Control signal). Accordingly, the first transistor 325 may be turned off and the driving current flowing through the light emitting device 200 may be stopped, and thereby a light emitting time of the light emitting device 200 can be controlled.

In this case, an inclination of linear shift of the sweep signal may be the same for all driving circuits 300 included in a display panel, and the gate terminal voltage of the fourth transistor 331 may be linearly shifted from a voltage based on the threshold voltage and pulse width setup voltage of the fourth transistor 331 according to an input of the sweep signal.

Accordingly, a time required for the gate terminal voltage of the fourth transistor 331 to reach the threshold voltage of the fourth transistor 331 after the sweep signal is applied differs according to an amplitude of the pulse width setup voltage, and thus the PWM driving circuit 330 may express a variety of grayscales or gradations according to the amplitude of the pulse width setup voltage.

In addition, a driving time of a driving current (that is, a pulse width of a driving current) flowing through the first transistor 325 is a period from when the gate terminal voltage of the fourth transistor 331 is linearly shifted in response to the input sweep signal until it reaches the threshold voltage of the fourth transistor 331, and thus is properly determined regardless of the threshold voltage of the fourth transistor 331.

According to an embodiment, it is possible to compensate a deviation of threshold voltage among the fourth transistors 331 included in each of a plurality of driving circuits included in a plurality of pixels of the display panel 1000 and/or 1000'.

As illustrated in FIG. 8, it may be understood that the display panel 1000 and/or 1000' according to various embodiments is a display panel of an active matrix (AM) drive method where the driving circuit 300 for driving the respective sub pixels is implemented as a TFT.

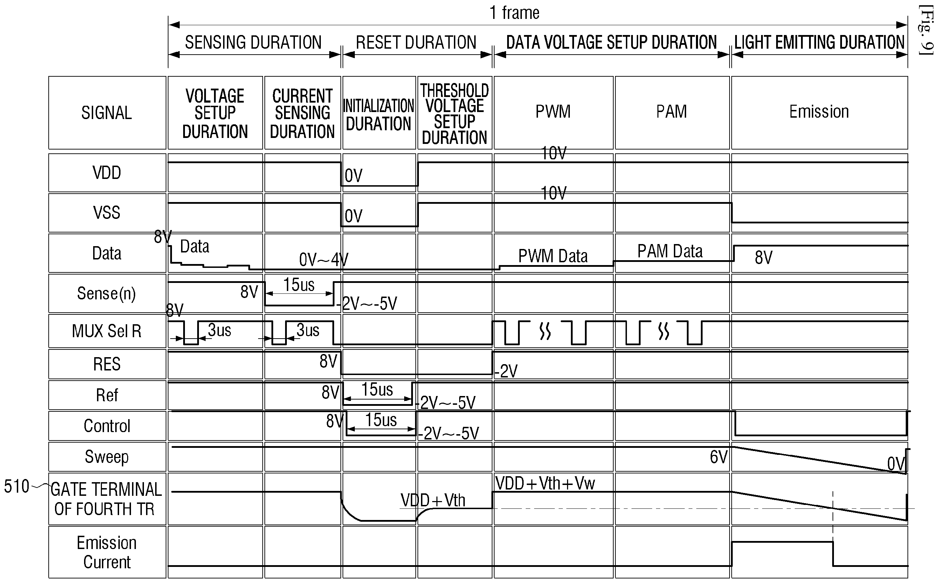

FIG. 9 is a timing diagram of various signals for driving the driving circuit 300 of FIG. 8, according to an embodiment. FIG. 9 illustrates a case where the driving circuit 300 is included in a red sub pixel (in other words, an R sub pixel is selected through a multiplexer (Mux) from among R, G and B sub pixels). The various voltages and times illustrated in FIG. 9 are only an example, and the example is not limited to the corresponding values.

Referring to FIG. 9, the driving circuit 300 may be, while one image frame is displayed, driven in the order of a sensing duration, a reset duration, a data voltage setup duration, and a light emitting duration.

The sensing duration is a duration for sensing a current flowing through the first transistor 325. The sensing duration may include a voltage setup duration for applying a particular voltage to the gate terminal of the first transistor 325, and a current sensing duration for sensing a current flowing through the first transistor 325 corresponding to the particular voltage.

The particular voltage is a voltage distinct from an amplitude setup voltage determining an amplitude of a driving current provided to the light emitting device 200. The particular voltage is a voltage for sensing the current flowing through the first transistor 325 corresponding to the particular voltage and correcting a deviation of threshold voltage among the first transistors 325 included in each of the plurality of driving circuits 300.

In detail, when the third transistor 311 is turned on according to the control signal (SPAM(n)) within the voltage setup duration, the particular voltage is charged in the first capacitor 312 through the data line 5. Thereafter, when the second transistor 340 is turned on according to the Sense signal within the current sensing duration, a current corresponding to the particular voltage flowing through the first transistor 325 may be transferred to the data line 5 through the second transistor 340.

The particular voltage may be variously set according to embodiments. For example, a particular voltage for sensing a driving voltage (that is, typical current) when the display panel is normally driven and a particular voltage for sensing a driving current (that is, peak current) when the display panel is driven at a maximum brightness may be different from each other, and as necessary, a particular voltage of different amplitudes may be applied through the data line 5 during the voltage setup duration.

As described above, the current flowing through the data line 5 may be sensed by a current sensor outside of the driving circuit 300. Accordingly, according to an embodiment, a processor or timing controller (TCON) outside of the driving circuit 300 may correct an amplitude setup voltage for each of the driving circuits 300 on the basis of a current sensed as described above, and apply the corrected amplitude setup voltage to the PAM driving circuit 310 during the data voltage setup duration, and thereby a deviation of threshold voltage among the first transistors 325 included in each of the plurality of driving circuits 300 included in the display panel can be compensated.

For example, if a particular voltage applied to the gate terminal of the first transistor 325 during the voltage setup duration is a and an amplitude of the sensed current is x, the processor or the timing controller (TCON) may identify an amplitude of current (for example, y) corresponding to the voltage a from a pre-stored table with which a particular voltage and an amplitude of current are mapped.

Accordingly, if the sensed current x is greater than y, that is, if the sensed current is greater than a current according to the pre-stored table, the processor or the timing controller (TCON) may correct an amplitude setup voltage to be applied to the first transistor 325 during the actual data voltage setup duration afterwards to be less than an amplitude setup voltage that would originally have been applied without the correction. If x is less than y, the amplitude setup voltage may be corrected to have an even higher value and applied to the PAM driving circuit 310.

Accordingly, it is possible to compensate the deviation of threshold voltage among the first transistors 325 included in each of the plurality of driving circuits 300 included in the plurality of pixels of the display panel.

The reset duration is a period for setting the gate terminal voltage of the fourth transistor 331 to a voltage based on the threshold voltage of the fourth transistor 331. The reset duration may include an initialization duration for setting the gate terminal voltage of the fourth transistor 331 and/or the gate terminal voltage of the first transistor 325 to a preset reference voltage, and a threshold voltage setup duration for setting the gate terminal voltage of the fourth transistor 331 to a voltage based on the threshold voltage of the fourth transistor 331.

When the reset duration is started, the fifth transistor 332 may be turned on according to a control signal (RES).While the fifth transistor 332 is turned on, the sixth transistor 333 may be turned on or off according to a control signal (Ref).That is, the sixth transistor 333 may be, as illustrated in FIG. 9, turned on and then turned off during an initialization duration.

When the sixth transistor 333 is turned on, a preset reference voltage (in the example of FIG. 9, a predetermined voltage in the range of 0V to 4V) may be applied to the gate terminal of the fourth transistor 331 through the data line 5, and thus the gate terminal voltage of the fourth transistor 331 may be, as illustrated in reference numeral 510 of FIG. 9, set to the reference voltage while the sixth transistor 333 is turned on.

Thereafter, when a threshold voltage setup duration is started, the sixth transistor 333 may be turned off, and accordingly, the gate terminal voltage of the fourth transistor 331 may be set to a voltage corresponding to the sum of the driving voltage (VDD) and the threshold voltage (Vth) of the fourth threshold voltage 331.

Referring to FIG. 9, the eighth transistor 350 is turned on according to the Control signal while the sixth transistor 333 is turned on , and thus a reference voltage applied to the gate terminal of the fourth transistor 331 may be applied the same to the gate terminal of the first transistor 325. That is, during the initialization duration, both the gate terminal voltage of the fourth transistor 331 and the gate terminal voltage of the first transistor 325 may be set to a predetermined reference voltage (for example, 0V).

As described above, the gate terminal voltage of the fourth transistor 331 and the gate terminal voltage of the first transistor 325 may be clearly set to a reference voltage prior to the threshold voltage setup duration, thereby preventing an inaccurate operation due to floating of the gate terminal voltage of the fourth threshold voltage 331.

The data voltage setup duration is a period for respectively applying a pulse width setup voltage (PWM data) and an amplitude setup voltage (PAM data) to the PWM driving circuit 330 and the PAM driving circuit 310.

For example, when the seventh transistor 336 is turned on according to the control signal (SPWM(n)) during the data voltage setup duration, a pulse width setup voltage is applied through the data line 5 to the gate terminal of the fourth transistor 331 through the second capacitor 334.

Accordingly, the gate terminal voltage of the fourth transistor 331 may, as illustrated in reference numeral 510 of FIG. 9, rise by a pulse width setup voltage (Vw), and the increased voltage may be maintained by the second capacitor 334.

When the third transistor 311 is turned on according to the control signal (SPAM(n)) during the data voltage setup duration, an amplitude setup voltage applied through the data line 5 may be charged in the first capacitor 312 and maintained. In this case, the amplitude setup voltage applied through the data line 5 may be a voltage which is corrected based on a current flowing through the first transistor 325 sensed during the sensing duration.

In the example of FIG. 9, a PWM data, that is, a pulse width setup voltage is applied first and then, a PAM data, that is, an amplitude setup voltage, is applied. However, the example is not limited thereto, and according to embodiments, the PWM data may be applied after a PAM data is applied.

The light emitting duration is a period for which the light emitting device 200 emits light according to a pulse width setup voltage and an amplitude setup voltage. As illustrated in FIG. 9, when a light emitting duration is started, a voltage of a ground voltage terminal 322 of the driving circuit 300 may fall to a ground voltage (VSS, for example, 0V), and the first transistor 325 may be accordingly turned on and a driving current of an amplitude corresponding to the amplitude setup voltage charged in the first capacitor 312 may be provided to the light emitting device 200. Accordingly, the light emitting device 200 initiates light emission.

When the light emitting duration is started, a sweep voltage may be applied to one terminal of the second capacitor 334 through the third capacitor 335, and thus the gate terminal voltage of the fourth transistor 331 connected to the other terminal of the second capacitor 334 may be linearly reduced from the maintained voltage (VDD + Vth + Vw) according to the sweep voltage.

When the gate terminal voltage of the fourth transistor 331 being linearly reduced reaches the threshold voltage Vth of the fourth transistor 331, the fourth transistor 331 may be turned on, and a driving voltage VDD may be applied to the gate terminal of the first transistor 325 via the eighth transistor 350. Accordingly, when the first transistor 325 is turned off, the driving current may be blocked and the light emitting device 200 stops emitting light.

That is, the light emitting device 200 may emit light from a time when a light emitting duration is started until the gate terminal voltage of the fourth transistor 331 is linearly reduced according to a sweep voltage and reaches the threshold voltage Vth of the fourth transistor 331.

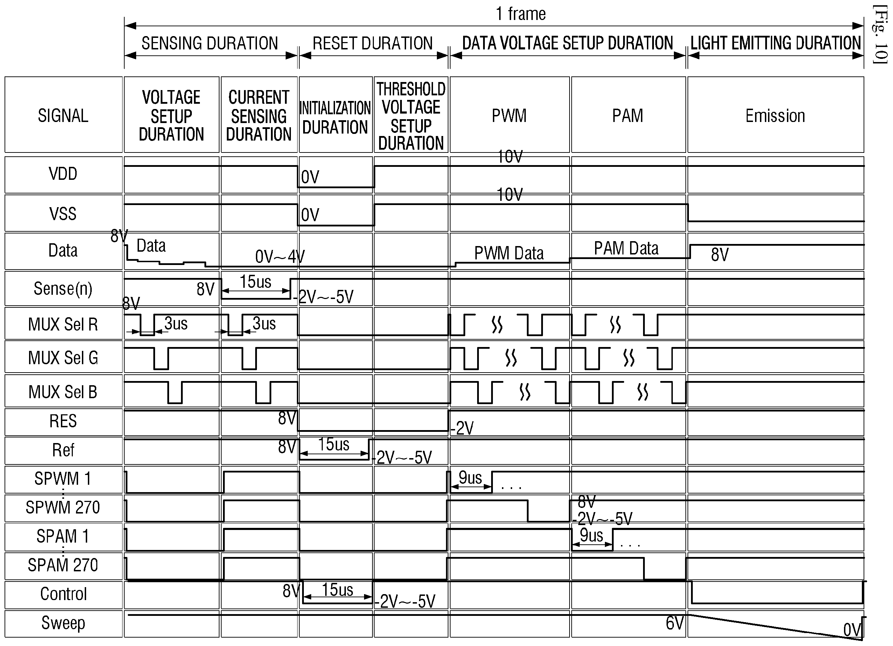

FIG. 10 is a timing diagram of various signals for driving an entire plurality of driving circuits included in a display panel. In FIG. 10, the same elements described above will not be described in detail. The numerical figures of various voltages and times illustrated in FIG. 10 are only an example, and are not limited to the corresponding values.

As described above, a plurality of pixels respectively including R, G and B sub pixels are arranged in the display panel 1000 and/or 1000'. Accordingly, the display panel 1000 and/or 1000' includes a plurality of light emitting devices and a plurality of driving circuits for driving the plurality of light emitting devices. FIG. 10 illustrates an embodiment of the display panel 1000 and/or 1000' in which the plurality of pixels are configured as 270 horizontal lines.

Accordingly, referring to FIG. 10, it may be understood that in control signals SPWM and SPAM, SPWM 1 to SPWM 270 and SPAM 1 to SPAM 270 are respectively driven in sequence during the data voltage setup duration.

According to an embodiment, the R, G and B sub pixels included in the respective pixels of the display panel 1000 and/or 1000' may have a structure of being connected to a single data line 5. The R, G and B sub pixels may respectively receive different data voltages applied through the data line 5 via a multiplexer (Mux, which includes MUX Sel R, MUX Sel G, and MUX Sel B).

That is, as illustrated in FIG. 10, the R, G and B sub pixels included in the respective pixels of the display panel 1000 and/or 1000' may be time-division driven (or, sequentially selected) through a Mux during the data voltage setup duration, and receive input of a pulse width setup voltage or amplitude setup voltage of different magnitudes from the data line 5.

This operation is applied in the same way during the sensing duration. As illustrated in FIG. 10, the R, G and B sub pixels included in the respective pixels of the display panel 1000 and/or 1000' may be sequentially selected through the Mux during the voltage setup duration and receive input of a particular voltage of different magnitudes from the data line 5.

In this case, a particular voltage input to the respective R, G and B sub pixels may be a value which is theoretically or experimentally determined based on a type of a sub pixel. According to an embodiment, a particular voltage of different magnitudes may be input to the respective R, G and B sub pixels, or a particular voltage of the same magnitude may be input to the respective R, G and B sub pixels.

In addition, the display panel 1000 and/or 1000' may be driven in such a way that a current flowing through the first transistor 325 of the driving circuit 300 corresponding to the R, G and B sub pixels during the sensing duration is sensed in different durations within the current sensing duration.

In this case, according to an embodiment, the display panel 1000 and/or 1000' may be driven to sense a current flowing through first transistors 325 of a plurality of driving circuits included in a plurality of pixels included in one horizontal line (or one row) from among a plurality of pixels configured in a matrix form during the sensing duration.

That is, the display panel 1000 and/or 1000' may be driven to sense only a current flowing through the first transistors 325 of the plurality of driving circuits included in the plurality of pixels arranged on one horizontal line, with respect to one image frame.

That is, the display panel 1000 and/or 1000' may be driven to sense a current flowing through the first transistors 325 only with respect to one horizontal line per image frame.

In this case, the display panel 1000 and/or 1000' may be driven to sequentially shift a horizontal line for each image frame and sense a current flowing through the first transistors 325 included in the corresponding line.

In general, a time for which one image frame is displayed is a very short period of time that a viewer cannot recognize with the naked eye, and thus, even if only one horizontal line of one image frame is sensed as described above, it may be sufficient to compensate a deviation of threshold voltage among the first transistors.

However, the example is not limited thereto, and the display panel 1000 and/or 1000' may be driven to sense a current flowing through the first transistors included in two or more horizontal lines during the sensing duration for one image frame.

In the example described above, all transistors 325, 350, 311, 331, 332, 333, 336 and 340 included in the driving circuit 300 are implemented as a P-channel metal oxide semiconductor field effect transistor (PMOSFET), but are not limited thereto.

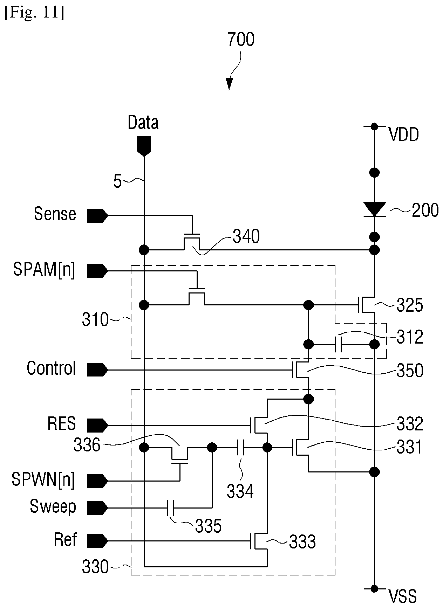

According to an embodiment, a driving circuit of which all transistors are implemented as an N-channel metal oxide semiconductor field effect transistor (NMOSFET) may be implemented to perform the same operation as the driving circuit 300 as described above. FIG. 11 illustrates a driving circuit of which all transistors are implemented as an NMOSFET.

The driving circuit 700 of FIG. 11 may perform the same operation as the driving circuit 300 of FIG. 8 excluding a difference due to a type of transistor (for example, a difference of connection relationship between devices and a difference of polarity of various signals to be applied). Accordingly, in the driving circuit 700 of FIG. 11, the same reference numeral is used for devices performing the same function as the devices included in the driving circuit 300 of FIG. 8. The configuration and operation of the driving circuit 700 would be easily understood by those skilled in the art through the description shown above, and thus the redundant description will be omitted herein.

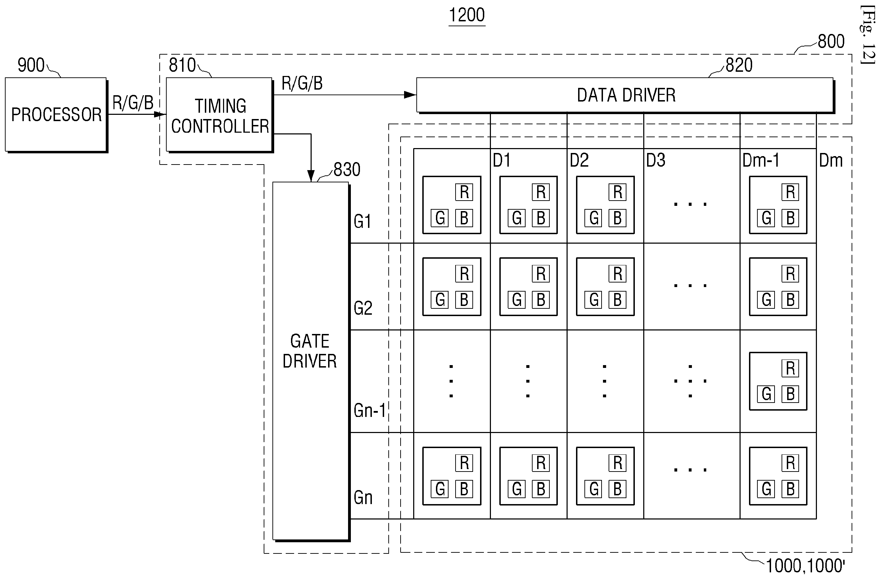

FIG. 12 is a diagram illustrating a configuration of a display apparatus, according to an embodiment. Referring to FIG. 12, a display apparatus 1200 includes a display panel 1000 and/or 1000', a panel driver 800, and a processor 900.

The display panel 1000 and/or 1000' includes a plurality of light emitting devices 200 included in a plurality of sub pixels, and a plurality of driving circuits 300 and/or 700 for driving the respective light emitting devices 200.

For example, the display panel 1000 and/or 1000' may be disposed such that gate lines G1 to Gn and data lines D1 to Dm intersect with each other, and the driving circuit 300 and/or 700 may be disposed in an area in which the intersection is provided. For example, the plurality of driving circuits 300 may be respectively configured such that adjacent R, G and B sub pixels form one pixel, but the example is not limited thereto.

In FIG. 12, for convenience of illustration, one gate signal line G1 to Gn is illustrated as a line for applying a control signal from the gate driver 830 to the respective driving circuits 300 and/or 700 included in the display panel 1000 and/or 1000'. However, the respective gate signal lines may include a Sense line (Sense 1 to Sense n), a SPWM line (SPWM 1 to SPWM n), and a SPAM line (SPAM 1 to SPAM n).

The panel driver 800 may be controlled by the processor 900 to drive the display panel 1000 and/or 1000' (in more detail, each of the plurality of driving circuits 300), and may include a timing controller 810, a data driver 820, and a gate driver 830.

The timing controller 810 may receive an input signal IS, a horizontal synchronizing signal Hsync, a vertical synchronizing signal Vsync and a main clock signal MCLK from the outside, and generate an image data signal, a scanning control signal, a data control signal, a light emission control signal, and the like to the display panel 1000 and/or 1000' and provide the generated signals to the display panel 1000 and/or 1000', the data driver 820, the gate driver 830, and the like.

For example, the timing controller 810 may, according to various embodiments, apply a control signal (Ref), a control signal (Sweep), a control signal (RES), a control signal (Control), and a control signal (MUX Sel R, G, B) to the driving circuit 300 and/or 700.

The data driver 820 (or source driver) may, as a means for generating a data signal, receive an image data of a R/G/B component from the processor 900 and generate a data signal (for example, a particular voltage, an amplitude setup voltage, and a pulse width setup voltage). In addition, the data driver 820 may apply the generated data signal to the display panel 1000 and/or 1000'.

The gate driver 830 may, as a means for generating various control signals such as a control signal (Sense), a control signal (SPWM), a control signal (SPAM), and the like, transfer the generated various control signals to a particular row (or a particular horizontal line) of the display panel 1000 and/or 1000'.

For example, in the driving circuit 300 and/or 700 to which the control signal (Sense) has been transferred, the second transistor 340 may be turned on and a current flowing through the first transistor 325 may be sensed through the data line 5. In addition, in the driving circuit 300 and/or 700 to which the control signal (SPAM) has been transferred, the third transistor 311 may be turned on and an amplitude setup voltage output from the data driver 820 may be transferred through the data line 5. In addition, in the driving circuit 300 and/or 700 to which the control signal (SPAM) has been transferred, the seventh transistor 336 may be turned on and a pulse width setup voltage output from the data driver 820 may be transferred through the data line 5.

In addition, the gate driver 830 may apply a driving voltage (VDD) to the driving voltage terminal 321 of the driving circuit 300 and/or 700 according to an embodiment.

Some or all of the data driver 820 and the gate driver 830 may, as described above, be included in a TFT layer 300' disposed on one surface of the glass 100 of the display panel 1000 and/or 1000' or implemented as an additional semiconductor integrated circuit (IC) and arranged on the other surface of the glass 100.

The processor 900 may include various processing circuitry and controls overall operations of the display apparatus 1200. In particular, the processor 900 may control the panel driver 800 to drive the display panel 1000 and/or 1000' so that the driving circuit 300 and/or 700 performs the operations described above.

To this end, the processor 900 may include one or more of a central processing unit (CPU), micro-controller, application processor (AP), communication processor (CP), ARM processor, or the like.

For example, according to an embodiment, the processor 900 may set a pulse width of a driving current according to a pulse width setup voltage, and control the panel driver 800 to set an amplitude of the driving current according to an amplitude setup voltage. In a case that the display panel 1000 and/or 1000' includes n columns and m rows, the processor 900 may control the panel driver 800 to set an amplitude or pulse width of the driving current by the row (by the horizontal line).

Thereafter, the processor 900 may collectively apply a driving voltage (VDD) to the plurality of driving circuits 300 and/or 700 via the current source 320 of the plurality of driving circuits 300 and/or 700, and control the panel driver 800 to apply a linear shift voltage (sweep signal) to a PWM driving circuit 330 of each of the plurality of driving circuits 300 and/or 700, and thereby an image can be displayed.

In this case, the detail of the processor 900 controlling the panel driver 800 to control an operation of the respective driving circuits 300 and/or 700 included in the display panel 1000 and/or 1000' is as described above with reference to FIGS. 7 to 11 and thus, the overlapped description will be omitted.

In the example described above, the processor 900 and the timing controller 810 are separate elements. However, the timing controller 810 may perform a function of the processor 900 without the processor 900.

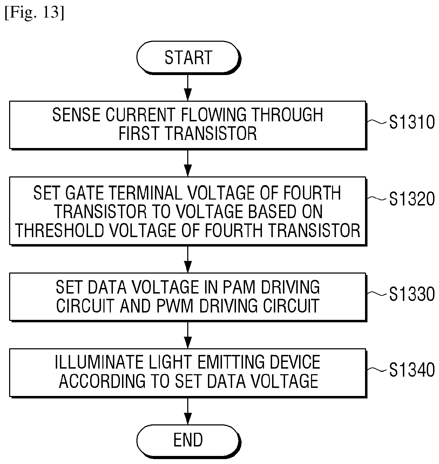

FIG. 13 is a flowchart illustrating a method for driving a display panel, according to an embodiment.

According to an embodiment, the display panel 1000 and/or 1000' may be driven in the order of a sensing duration, a reset duration, a data voltage setup duration, and a light emitting duration for one image frame.

Referring to FIG. 13, the display panel 1000 and/or 1000' may be driven in such a way that a current flowing through the first transistor 325 included in the driving circuit 300 and/or 700 is sensed by an external processor or a timing controller during the sensing duration, at operation S1310.

For example, in the display panel 1000 and/or 1000', when the third transistor 311 of the driving circuit 300 and/or 700 is turned on according to the control signal (SPAM(n)) within the voltage setup duration during the sensing duration, a particular voltage may be charged in the first capacitor 312 of the driving circuit 300 and/or 700 through the data line 5. Thereafter, when the second transistor 340 of the driving circuit 300 and/or 700 is turned on according to the Sense signal within the current sensing duration during the sensed duration, a current corresponding to the particular voltage flowing through the first transistor 325 may be transferred to the data line 5 through the second transistor 340.

The current transferred to the data line 5 as described above may be sensed by an external processor or timing controller connected to the data line 5, and the external processor or the timing controller may correct an amplitude setup voltage to be later applied to the PAM driving circuit 310 of the driving circuit 300 and/or 700 based on the sensed current.

In addition, the display panel 1000 and/or 1000' may be driven so that the gate terminal voltage of the fourth transistor 331 of the driving circuit 300 and/or 700 during the reset duration is set to a voltage based on the threshold voltage of the fourth transistor 331, at operation S1320.

For example, in the display panel 1000 and/or 1000', when the reset duration is started, the fifth transistor 332 of the driving circuit 300 and/or 700 may be turned on according to the RES signal. While the fifth transistor 332 is turned on, the sixth transistor 333 of the driving circuit 300 and/or 700 may be turned on or off according to the Ref signal. Accordingly the gate terminal voltage of the fourth transistor 331 may be set to a predetermined reference voltage while the sixth transistor 333 is turned on during the reset duration (that is, during the initialization duration), and may be set to a voltage based on the threshold voltage of the fourth transistor 331 while the sixth transistor is turned off during the reset duration (that is, during the threshold voltage setup duration).

In addition, the display panel 1000 and/or 1000' may be driven during the data voltage setup duration so that a data voltage is set up in the PAM driving circuit 310 and the PWM driving circuit 330, at operation S1330.

For example, the display panel 1000 and/or 1000' may be, when the seventh transistor 336 of the driving circuit 300 and/or 700 is turned on according to the control signal (SPWM(n)) during the data voltage setup duration, driven so that a pulse width setup voltage applied through the data line 5 is applied to the gate terminal of the fourth transistor 331 through the second capacitor 334 of the driving circuit 300 and/or 700. Accordingly, the gate terminal voltage of the fourth transistor 331 may be set to a voltage based on a threshold voltage and pulse width setup voltage of the fourth transistor 331.

In addition, the display panel 1000 and/or 1000' may be, when the third transistor 311 of the driving circuit 300 and/or 700 is turned on according to the control signal (SPAM(n)) during the data voltage setup duration, driven so that an amplitude setup voltage applied through the data line 5 is charged in the first capacitor 312 of the driving circuit 300 and/or 700. In this case, the amplitude setup voltage applied through the data line 5 may be a voltage which is corrected based on a current flowing through the first transistor 325 sensed during the sensing duration.

In addition, the display panel 1000 and/or 1000' may be, during the light emitting duration, driven so that the light emitting device 200 emits light according to the pulse width setup voltage and the amplitude setup voltage, at operation S1340.

When the light emitting duration is started, a sweep voltage may be applied to one terminal of the second capacitor 334 through the third capacitor 335, and thus the gate terminal voltage of the fourth transistor 331 connected to the other terminal of the second capacitor 334 may be linearly reduced from the maintained voltage (VDD + Vth + Vw) according to the sweep voltage. When the gate terminal voltage of the fourth transistor 331 being linearly reduced reaches the threshold voltage Vth of the fourth transistor 331, the fourth transistor 331 may be turned on, and a driving voltage VDD may be applied to the gate terminal voltage of the first transistor 325 via the eighth transistor 350. Accordingly, when the first transistor 325 is turned off, the driving current may be blocked and the light emitting device 200 stops emitting light. That is, the light emitting device 200 may emit light from a time when a light emitting duration is started until the gate terminal voltage of the fourth transistor 331 is linearly reduced according to a sweep voltage and reaches the threshold voltage Vth of the fourth transistor 331.

In the example described above, the light emitting device 200 is a micro LED, but is not limited thereto. That is, according to an embodiment, even when the light emitting device 200 is an LED of a size greater than or equal to 100 micrometers, the driving circuit 300 and/or 700 according to the various embodiments described above may be applied.

In addition, in the example described above, the display panel 1000 and/or 1000' is a chip-on-glass (COG) type, but according to an embodiment, the driving circuit 300 and/or 700 according to the various embodiments described above may be applied to a display panel of a chip-on-board (COB) type. As for a display panel of a COB type, a substrate is used instead of the glass 100 unlike the COG type. In this case, a hole penetrating the substrate is formed and one surface of the substrate and the other surface of the substrate are electrically connected through the hole, and thereby the driving circuit 300 and/or 700 provided on one surface of the substrate and various circuits provided on the other surface of the substrate can be electrically connected to each other.

According to an embodiment, the display panel 1000 and/or 1000' may be implemented as an independent display panel without extensibility. However, the example is not limited thereto, and the display panel 1000 and/or 1000' may be implemented as an extensible display module included in some of a large-area tiled display.

According to the various embodiments, a wavelength shift according to a grayscale or gradation of a light emitting device included in a display panel can be prevented. In addition, it is possible to correct a stain or color of the light emitting device included in the display panel. In addition, even in a case that a large-area tiled display panel is configured by combining a display panel in the form of a plurality of modules, a difference of brightness or color among the respective modular display panels can be corrected.

The above-described embodiments may be implemented as a software program including an instruction stored on machine (e.g., computer)-readable storage media. The machine is an apparatus which is capable of calling a stored instruction from the storage medium and operating according to the called instruction, and may include a display apparatus 1200 according to the above-described embodiments.

When the command is executed by a processor, the processor may perform a function corresponding to the command directly or using other components under the control of the processor. The command may include a code generated or executed by a compiler or an interpreter. A machine-readable storage medium may be provided in the form of a non-transitory storage medium. Herein, the term "non-transitory" only denotes that a storage medium does not include a signal but is tangible, and does not distinguish the case where data is semi-permanently stored in a storage medium from the case where data is temporarily stored in a storage medium.

According to an embodiment, the method according to the above-described various embodiments may be provided as being included in a computer program product. The computer program product may be traded as a product between a seller and a consumer. The computer program product may be distributed in the form of (e.g., a compact disc read only memory (CD-ROM)) or through an application store (e.g., PlaystoreTM).In the case of online distribution, at least a portion of the computer program product may be at least temporarily stored or temporarily generated in a server of the manufacturer, a server of the application store, or a storage medium such as memory.

Each of the components (e.g., module or program) according to the various embodiments may include a single entity or a plurality of entities, and some of the corresponding sub components described above may be omitted, or another sub component may be further added to the various embodiments. Alternatively or additionally, some components (e.g., module or program) may be combined to form a single entity which performs the same or similar functions as the corresponding elements before being combined. Operations performed by a module, a program, or other component, according to various embodiments, may be sequential, parallel, or both, executed iteratively or heuristically, or at least some operations may be performed in a different order, omitted, or other operations may be added.

Although embodiments of the present disclosure have been illustrated and described, it should be understood that the present disclosure is not limited to the disclosed embodiments and may be variously changed without departing from the spirit and the scope of the present disclosure. While the disclosure has been shown and described with reference to various embodiments thereof, it will be understood by those skilled in the art that various changes in form and details may be made therein without departing from the scope of the disclosure as defined by the appended claims.

## Claims

1. A display panel (1000) comprising:
a glass (100);
a plurality of pixels (10) arranged in a matrix form, each pixel from among the plurality of pixels including a plurality of sub pixels that respectively include inorganic light emitting devices (200); and
a plurality of driving circuits (300) configured to respectively provide a driving current to each of the inorganic light emitting devices included in the sub pixels,
wherein the plurality of driving circuits are disposed between the glass and the inorganic light emitting device, the driving circuits being configured to respectively provide the driving current to the inorganic light emitting devices and to control a magnitude and a pulse width of the driving current,
wherein the inorganic light emitting devices are mounted on the driving circuits and electrically connected to the driving circuits,
wherein each respective driving circuit from among the plurality of driving circuits comprises:
a current source (320) comprising a first transistor (325) connected to the corresponding inorganic light emitting device, the current source being configured to control the driving current provided to the inorganic light emitting device according to a voltage applied to a gate terminal of the first transistor;
a pulse amplitude modulation (PAM) driving circuit (310) configured for receiving an amplitude setup voltage via a data line and for applying said amplitude setup voltage to the gate terminal of the first transistor, the amplitude setup voltage determining the magnitude of the driving current; and
a pulse width modulation (PWM) driving circuit (330) configured for receiving a pulse width setup voltage via the data line and for controlling the pulse width of the driving current by controlling on/off of the first transistor based on the pulse width setup voltage applied to the PWM driving circuit,
wherein the PAM driving circuit comprises:
a second transistor (340) including a first terminal connected to the anode terminal of the corresponding inorganic light emitting device, a second terminal connected to the data line and a gate terminal configured for receiving a control signal "Sense";
a third transistor (311) including a source terminal connected to the data line (5), and a drain terminal connected to the gate terminal of the first transistor and having a gate terminal configured for receiving a control signal "SPAM(n)"; and
a first capacitor (312) including a first terminal connected to a source terminal of the first transistor, and a second terminal commonly connected to the gate terminal of the first transistor and the drain terminal of the third transistor,
a fourth transistor (331) having a source terminal connected to a driving voltage terminal (321);
a fifth transistor (332) for performing a Vth internal compensation connected between a gate terminal of the fourth transistor and a drain terminal of the fourth transistor and having a gate terminal configured for receiving a control signal "RES";
a sixth transistor (333) including a source terminal connected to the data line, and a drain terminal commonly connected to the gate terminal of the fourth transistor and a source terminal of the fifth transistor, and having a gate terminal configured for receiving a control signal "Ref";
a second capacitor (334) including a first terminal commonly connected to the gate terminal of the fourth transistor, the source terminal of the fifth transistor, and the drain terminal of the sixth transistor;
a third capacitor (335) including a first terminal configured for receiving a linearlyshifting sweep signal "Sweep", and a second terminal connected to a second terminal of the second capacitor; and
a seventh transistor (336) including a source terminal connected to the data line, and a drain terminal commonly connected to the second terminal of the second capacitor and the second terminal of the third capacitor, and a gate terminal configured for receiving a control signal "SPWM(n)",
wherein the each respective driving circuit further comprises an eighth transistor (350) including a drain terminal connected to the gate terminal of the first transistor, and a source terminal commonly connected to the drain terminal of the fourth transistor and a drain terminal of the fifth transistor, and a gate terminal configured for receiving a control signal "Control",
wherein the source terminal of the first transistor is commonly connected to the first terminal of the first capacitor and to the driving voltage terminal (321),
wherein the drain terminal of the first transistor is connected to the anode terminal of the corresponding inorganic light emitting device, and
wherein a cathode terminal of the corresponding inorganic light emitting device is connected to a ground voltage terminal (322) of the driving circuit.

2. The display panel as claimed in claim 1,
wherein each pixel from among the plurality of pixels includes an R sub pixel including a red (R) inorganic light emitting device, a G sub pixel including a green (G) inorganic light emitting device, and a B sub pixel including a blue (B) inorganic light emitting device.

## Patentansprüche

1. Anzeigetafel (1000), umfassend:
ein Glas (100);
eine Vielzahl von Pixeln (10), die in einer Matrixform positioniert ist, wobei jedes Pixel aus der Vielzahl von Pixeln eine Vielzahl von Subpixeln beinhaltet, die jeweils anorganische lichtemittierende Vorrichtungen (200) beinhalten; und
eine Vielzahl von Antriebsschaltungen (300), die dazu konfiguriert ist, jeder der anorganischen lichtemittierenden Vorrichtungen, die in den Subpixeln beinhaltet ist, jeweils einen Antriebsstrom bereitzustellen,
wobei die Vielzahl von Antriebsschaltungen zwischen dem Glas und der anorganischen lichtemittierenden Vorrichtung angeordnet ist, wobei die Antriebsschaltungen dazu konfiguriert sind, jeweils den Antriebsstrom den anorganischen lichtemittierenden Vorrichtungen bereitzustellen und eine Größe und eine Impulsbreite des Antriebsstroms zu steuern,
wobei die anorganischen lichtemittierenden Vorrichtungen an den Antriebsschaltungen montiert und elektrisch mit den Antriebsschaltungen verbunden sind,
wobei jede jeweilige Antriebsschaltung aus der Vielzahl von Antriebsschaltungen Folgendes umfasst:
eine Stromquelle (320), die einen ersten Transistor (325) umfasst, der mit der entsprechenden anorganischen lichtemittierenden Vorrichtung verbunden ist, wobei die Stromquelle dazu konfiguriert ist, den Antriebsstrom, der der anorganischen lichtemittierenden Vorrichtung bereitgestellt wird, gemäß einer Spannung zu steuern, die an einen Gate-Anschluss des ersten Transistors angelegt wird;
eine Pulsamplitudenmodulations(PAM)-Antriebsschaltung (310), die zum Empfangen einer Amplitudeneinstellungsspannung über eine Datenleitung und zum Anlegen der Amplitudeneinstellungsspannung an den Gate-Anschluss des ersten Transistors konfiguriert ist, wobei die Amplitudeneinstellungsspannung die Größe des Antriebsstroms bestimmt; und
eine Pulsbreitenmodulations(PWM)-Antriebsschaltung (330), die zum Empfangen einer Pulsbreiteneinstellungsspannung über die Datenleitung und zum Steuern der Pulsbreite des Antriebsstroms durch Steuern des Ein-/Ausschaltens des ersten Transistors basierend auf der Pulsbreiteneinstellungsspannung, die an die PWM-Antriebschaltung angelegt wird, konfiguriert ist,
wobei die PAM-Antriebsschaltung Folgendes umfasst:
einen zweiten Transistor (340), der einen ersten Anschluss, der mit dem Anodenanschluss der entsprechenden anorganischen lichtemittierenden Vorrichtung verbunden ist, einen zweiten Anschluss, der mit der Datenleitung verbunden ist, und einen Gate-Anschluss, der zum Empfangen eines Steuersignals "Sense" konfiguriert ist, beinhaltet;
einen dritten Transistor (311), der einen Source-Anschluss, der mit der Datenleitung (5) verbunden ist, und einen Drain-Anschluss, der mit dem Gate-Anschluss des ersten Transistors verbunden ist, beinhaltet und einen Gate-Anschluss aufweist, der zum Empfangen eines Steuersignals "SPAM(n)" konfiguriert ist; und
einen ersten Kondensator (312), der einen ersten Anschluss, der mit einem Source-Anschluss des ersten Transistors verbunden ist, und einen zweiten Anschluss, der gemeinsam mit dem Gate-Anschluss des ersten Transistors und dem Drain-Anschluss des dritten Transistors verbunden ist, beinhaltet,
einen vierten Transistor (331), der einen Source-Anschluss, der mit einem Antriebsspannungsanschluss (321) verbunden ist, aufweist;
einen fünften Transistor (332) zum Durchführen einer V-ten internen Kompensation, der zwischen einem Gate-Anschluss des vierten Transistors und einem Drain-Anschluss des vierten Transistors verbunden ist und einen Gate-Anschluss aufweist, der zum Empfangen eines Steuersignals "RES" konfiguriert ist;
einen sechsten Transistor (333), der einen Source-Anschluss, der mit der Datenleitung verbunden ist, und einen Drain-Anschluss, der gemeinsam mit dem Gate-Anschluss des vierten Transistors und einem Source-Anschluss des fünften Transistors verbunden ist, beinhaltet und einen Gate-Anschluss aufweist, der zum Empfangen eines Steuersignals "Ref" konfiguriert ist;
einen zweiten Kondensator (334), der einen ersten Anschluss, der gemeinsam mit dem Gate-Anschluss des vierten Transistors, dem Source-Anschluss des fünften Transistors und dem Drain-Anschluss des sechsten Transistors verbunden ist, beinhaltet;
einen dritten Kondensator (335), der einen ersten Anschluss, der zum Empfangen eines sich linear verschiebenden Sweep-Signals "Sweep" konfiguriert ist, und einen zweiten Anschluss, der mit einem zweiten Anschluss des zweiten Kondensators verbunden ist, beinhaltet; und
einen siebten Transistor (336), der einen Source-Anschluss, der mit der Datenleitung verbunden ist, und einen Drain-Anschluss, der gemeinsam mit dem zweiten Anschluss des zweiten Kondensators und dem zweiten Anschluss des dritten Kondensators verbunden ist, und einen Gate-Anschluss, der zum Empfangen eines Steuersignals "SPWM(n)" konfiguriert ist, beinhaltet,
wobei jede jeweilige Antriebsschaltung ferner einen achten Transistor (350), der einen Drain-Anschluss, der mit dem Gate-Anschluss des ersten Transistors verbunden ist, und einen Source-Anschluss, der gemeinsam mit dem Drain-Anschluss des vierten Transistors und einem Drain-Anschluss des fünften Transistors verbunden ist, und einen Gate-Anschluss beinhaltet, der zum Empfangen eines Steuersignals "Control" konfiguriert ist, umfasst,
wobei der Source-Anschluss des ersten Transistors gemeinsam mit dem ersten Anschluss des ersten Kondensators und dem Antriebsspannungsanschluss (321) verbunden ist,
wobei der Drain-Anschluss des ersten Transistors mit dem Anodenanschluss der entsprechenden anorganischen lichtemittierenden Vorrichtung verbunden ist, und
wobei ein Kathodenanschluss der entsprechenden anorganischen lichtemittierenden Vorrichtung mit einem Massespannungsanschluss (322) der Antriebsschaltung verbunden ist.

2. Anzeigetafel nach Anspruch 1,
wobei jedes Pixel aus der Vielzahl von Pixeln ein R-Subpixel, das eine rote (R) anorganische lichtemittierende Vorrichtung beinhaltet, ein G-Subpixel, das eine grüne (G) anorganische lichtemittierende Vorrichtung beinhaltet, und ein B-Subpixel, das eine blaue (B) anorganische lichtemittierende Vorrichtung beinhaltet, beinhaltet.

## Revendications

1. Panneau d'affichage (1000), comprenant :
un verre (100) ;
une pluralité de pixels (10) agencés en forme de matrice, chaque pixel parmi la pluralité de pixels comprenant une pluralité de sous-pixels qui comprennent respectivement des dispositifs électroluminescents inorganiques (200) ; et
une pluralité de circuits d'attaque (300) configurés pour fournir respectivement un courant d'attaque à chacun des dispositifs électroluminescents inorganiques compris dans les sous-pixels,
ladite pluralité de circuits d'attaque étant disposés entre le verre et le dispositif électroluminescent inorganique, les circuits d'attaque étant configurés pour fournir respectivement le courant d'attaque aux dispositifs électroluminescents inorganiques et pour commander une amplitude et une largeur d'impulsion du courant d'attaque,
lesdits dispositifs électroluminescents inorganiques étant montés sur les circuits d'attaque et connectés électriquement aux circuits d'attaque,
chaque circuit d'attaque respectif parmi la pluralité de circuits d'attaque comprenant :
une source de courant (320) comprenant un premier transistor (325) connecté au dispositif électroluminescent inorganique correspondant, la source de courant étant configurée pour commander le courant d'attaque fourni au dispositif électroluminescent inorganique selon une tension appliquée à une borne de grille du premier transistor ;
un circuit d'attaque de modulation d'amplitude d'impulsion (PAM) (310) configuré pour recevoir une tension de configuration d'amplitude par l'intermédiaire d'une ligne de données et pour appliquer ladite tension de configuration d'amplitude à la borne de grille du premier transistor, la tension de configuration d'amplitude déterminant l'amplitude du courant d'attaque ; et
un circuit d'attaque de modulation de largeur d'impulsion (PWM) (330) configuré pour recevoir une tension de configuration de largeur d'impulsion par l'intermédiaire de la ligne de données et pour commander la largeur d'impulsion du courant d'attaque en commandant la marche/l'arrêt du premier transistor sur la base de la tension de configuration de largeur d'impulsion appliquée au circuit d'attaque PWM,
ledit circuit d'attaque PAM comprenant :
un deuxième transistor (340) comprenant une première borne connectée à la borne d'anode du dispositif électroluminescent inorganique correspondant, une seconde borne connectée à la ligne de données et
une borne de grille configurée pour recevoir un signal de commande « Sense » ;
un troisième transistor (311) comprenant une borne de source connectée à la ligne de données (5), et une borne de drain connectée à la borne de grille du premier transistor et comportant une borne de grille configurée pour recevoir un signal de commande « SPAM(n) » ; et
un premier condensateur (312) comprenant une première borne connectée à une borne de source du premier transistor, et une seconde borne connectée en commun à la borne de grille du premier transistor et à la borne de drain du troisième transistor,
un quatrième transistor (331) comportant une borne de source connectée à une borne de tension d'attaque (321) ;
un cinquième transistor (332) destiné à effectuer une Vième compensation interne connectée entre une borne de grille du quatrième transistor et une borne de drain du quatrième transistor et comportant une borne de grille configurée pour recevoir un signal de commande « RES » ;
un sixième transistor (333) comprenant une borne de source connectée à la ligne de données, et une borne de drain connectée en commun à la borne de grille du quatrième transistor et à une borne de source du cinquième transistor, et comportant une borne de grille configurée pour recevoir un signal de commande « Ref » ;
un deuxième condensateur (334) comprenant une première borne connectée en commun à la borne de grille du quatrième transistor, à la borne de source du cinquième transistor et à la borne de drain du sixième transistor ;
un troisième condensateur (335) comprenant une première borne configurée pour recevoir un signal de balayage à décalage linéaire « Sweep », et une seconde borne connectée à une seconde borne du deuxième condensateur ; et
un septième transistor (336) comprenant une borne de source connectée à la ligne de données, et une borne de drain connectée en commun à la seconde borne du deuxième condensateur et à la seconde borne du troisième condensateur, et une borne de grille configurée pour recevoir un signal de commande « SPWM(n) »,
chaque circuit d'attaque respectif comprenant en outre un huitième transistor (350) comprenant une borne de drain connectée à la borne de grille du premier transistor, et une borne de source connectée en commun à la borne de drain du quatrième transistor et à une borne de drain du cinquième transistor, et une borne de grille configurée pour recevoir un signal de commande « Control »,
ladite borne de source du premier transistor étant connectée en commun à la première borne du premier condensateur et à la borne de tension d'attaque (321),
ladite borne de drain du premier transistor étant connectée à la borne d'anode du dispositif électroluminescent inorganique correspondant, et
une borne de cathode du dispositif électroluminescent inorganique correspondant étant connectée à une borne de tension de masse (322) du circuit d'attaque.

2. Panneau d'affichage selon la revendication 1,
chaque pixel parmi la pluralité de pixels comprenant un sous-pixel R comprenant un dispositif électroluminescent inorganique rouge (R), un sous-pixel G comprenant un dispositif électroluminescent inorganique vert (G) et un sous-pixel B comprenant un dispositif électroluminescent inorganique bleu (B).
